# EUROPÄISCHE PATENTSCHRIFT

(11) **EP 0 406 744 B1**
(45) Veröffentlichungstag und Bekanntmachung des Hinweises auf die Patenterteilung: **25.08.1999**
(21) Anmeldenummer: 90112543.5
(22) Anmeldetag: 30.06.1990
(51) Int. Cl.: G06F 17/21, G11B 20/10, G11B 27/036

(54) **Schaltungsanordnung zur Überarbeitung eines in einem Magnetband- und/oder Halbleiterspeicher abgespeicherten gesprochenen Textes**
Device for editing spoken text stored on a magnetic tape and/or in a semiconductor memory
Dispositif pour éditer un texte parlé, enregistré sur une bande magnétique et/ou dans une mémoire semi-conductrice

(30) Priorität: 04.07.1989 DE 3921942
(43) Veröffentlichungstag der Anmeldung: 09.01.1991
(73) Patentinhaber: GRUNDIG Aktiengesellschaft, 90762 Fürth (DE)
(72) Erfinder: Schröder Günter, Grundig E.M.V., Elektro-Mech.V., D-8510 Fuerth (DE); Dotter, Hans, Grundig E.M.V., Elektro-Mech.V., D-8510 Fuerth (DE)

(56) Entgegenhaltungen:
- EP-A- 0 065 148
- EP-A- 0 204 578
- EP-A- 0 322 100
- DE-A- 3 429 769
- GB-A- 2 199 984
- US-A- 3 936 805

## Beschreibung

Die Erfindung betrifft eine Schaltungsanordnung zur Überarbeitung eines abgespeicherten gesprochenen Textes gemäß dem Oberbegriff der Patentansprüche 1.

Diktier- und Schreibgeräte sind im Büro bei der Erstellung von Dokumenten seit langem bewährte Hilfsmittel. Für die wirtschaftliche Abwicklung des gesamten internen und externen Schriftverkehrs ist es besonders wichtig, die Arbeit für den Diktierer und die Sekretärin, Schreibkraft bzw. Phonotypistin zu erleichtern. Beispielsweise soll die Umsetzung des gesprochenen Textes in Schriftform möglichst schnell erfolgen, die Berichtigung einzelner Textpassagen eines diktierten Briefes möglichst einfach durchführbar sein usw..

Aus der DE-PS 21 59 848 ist ein Textverarbeitungssystem mit peripheren Diktateingabestellen und mit zentral angeordneten Diktatwiedergabe- und Schreibgeräten bekannt. Die über das Fernmeldenetz übertragenen Diktate werden im Schreibsekretariat abgehört und in den geschriebenen Text umgesetzt. Den verschiedenen peripheren Diktateingabestellen und den einzelnen Textabschnitten sind jeweils Kennungen zugeordnet. Die einzelnen Textabschnitte werden automatisch sortiert und zum vollständigen Text zusammengefügt. Eine unmittelbare Überprüfung der in den Textseitenspeichern gespeicherten Textabschnitte und das Vornehmen von Korrekturen, Umstellungen oder Einfügungen vor dem Ausdrucken des Textes wird dem Verfasser des Textes dadurch ermöglicht, daß jede Diktateingabestelle einen Anzeigebildschirm und eine Korrektureinrichtung aufweist. Dadurch ist der jeweils auf dem Bildschirm angezeigte und in dem jeweils zugeordneten Textseitenspeicher gespeicherte Text durch Löschen, Überschreiben, Einfügen von Schriftzeichen oder ähnlichen Operationen korrigierbar.

Ein solches Textverarbeitungssystem erleichtert zwar dem Diktierer die Arbeit und ermöglicht eine schnelle Textverarbeitung, erfordert jedoch vom Anwender hohe Investitionen. Als Massenspeicher für die Diktate bzw. Diktatabschnitte ist beim Textverarbeitungssystem gemäß der DE-PS 21 59 848 ein Magnetband-Speicher vorgesehen.

Im Laufe der Entwicklung von Speichertechnologien wurde untersucht, ob nicht auch andere Speicherfamilien für den Einsatzfall Text- bzw. Diktat-Speicherung günstiger sind. Da der Bedarf, große Informationsmengen zu speichern, von Jahr zu Jahr zunimmt und überwiegend Daten abzuspeichern sind, fanden zunehmend digitale Speicher ihre technische Anwendung.

Der Einsatz der digitalen Speicher wird im wesentlichen durch die Speicherkapazität, die Zugriffszeit, die Kosten pro Bit oder Byte und durch die Flüchtigkeit der gespeicherten Daten bestimmt. Für den Einsatzfall der Diktatspeicherung können Schreib-/Lese-Speicher mit wahlfreiem Zugriff oder seriellem Zugriff benutzt werden. Bei einem wahlfreien Zugriff (Random Access) wird ein bestimmter Speicherplatz (z.B. 2. Zeile, 6. Spalte) durch die Adresse erreicht. Bei einem Speicher mit seriellem (sequentiellem) Zugriff kann der Speicherplatz nicht direkt erreicht werden, sondern der Zugriff ist vom Ort der Speicherplätze abhängig. Ein Beispiel für einen seriellen Speicher sind Magnetband-Speicher, wobei diese Speicher in der Regel nur dort benutzt werden, wo es nicht auf kurze Zugriffszeiten ankommt. Magnetband-Speicher zeichnen sich infolge der hohen Aufzeichnungsdichte durch die geringen Kosten pro Bit, man rechnet hier mit Mikropfennigen pro Bit, und durch die Nichtflüchtigkeit der Daten aus.

Neben diesem nichtflüchtigen Schreib-/Lese-Speicher wurde auch die Eignung von flüchtigen Schreib-/Lese-Speichern, z.B. Halbleiterspeicher, untersucht. Der Vorteil der Halbleiterspeicher liegt in der kurzen Zugriffszeit, der hohen Packungsdichte, der einfachen Verknüpfung mit anderen Halbleiterbausteinen sowie der einfachen Möglichkeit der Speichererweiterung. Die wichtigsten Halbleiterspeicher sind heute die dynamischen und die statischen Schreib-/Lese-Speicher. Beim statischen RAM werden in der Regel die Daten in Flip-Flops gespeichert, während beim dynamischen RAM die Daten als Ladung in einem integrierten Kondensator gespeichert werden. Statische RAM benötigen zur Aufrechterhaltung der Daten dauernd einen bestimmten geringen Strom, während beim dynamischen RAM, infolge der Leckströme, die Ladung nach einer bestimmten Zeit (z.B. nach einigen Millisekunden) aufgefrischt werden muß.

Aus der DE-OS 34 29 769 ist ein Verfahren zur Texteingabe in ein Diktiergerät oder einen Anrufbeantworter bekannt, bei dem ein Halbleiterspeicher benutzt wird. Zur Korrektur von Textstellen bzw. zum Ersetzen von Textstellen durch neue Textteile, werden die Anfangs- und Endpunkte der auszutauschenden, gesprochenen Textteile durch einen Markierungscode bestimmt. Beim Einfügen des Markierungscodes wird jeweils der ursprüngliche Text im Halbleiterspeicher um die Codewortlänge verschoben. Nach der Markierung betätigt der Benutzer eine Korrekturtaste, wodurch eine Korrekturablaufsteuerung entweder die vorletzte Markierung am Ende oder die erste Markierung am Anfang des im digitalen Speicher befindlichen Textes ansteuert. Im seriellen Halbleiterspeicher wird je nach Länge des neuen Textteils der nachfolgende ursprüngliche Text von Speicherplatz zu Speicherplatz weitergeschoben oder aufgeschlossen, wofür der Benutzer eine Fülltaste betätigt.

Der hierbei aufgezeigte Weg des Einsatzes von Halbleiterspeichern für die Abspeicherung von Sprachdaten wird auch beim Gegenstand der EP-B1-0 065 148 bzw. EP-A1-0 273 764 beschritten. Im Vergleich von EP-B1-0 065 148 und DE-PS 21 59 848, ist bei der Zentraldiktatanlage gemäß der EP-B1-0 065 148 anstelle des Magnetband-Speichers ein Halbleiterspeicher eingesetzt.

Aus der EP 0 065 148 A2 ist insbesondere bekannt, daß bei einer Überarbeitung eines Diktats an den Stellen, an denen Löschungen oder Einfügungen erfolgen sollen, Sprungmarken gesetzt werden, die zu einer Sprunganweisung in einem Sprungspeicher verweisen. Im Sprungspeicher sind dann die bei der Überarbeitung eingegebenen Anweisungen zur Veränderung des Textes gespeichert. Beispielsweise wird bei einer Löschung der zu löschende Textteil übersprungen. Im Sprungspeicher steht dann die Stelle im Diktat, an der die Wiedergabe fortgesetzt werden soll. Soll an einer Stelle eine Einfügung erfolgen, wird von dieser Stelle zum Beginn der Einfügung gesprungen, die Einfügung wiedergegeben und danach wieder in den ursprünglichen Text an die Stelle der Einfügung zurückgesprungen. Dadurch wird bei einer Überarbeitung die logische Reihenfolge (die Reihenfolge der Wiedergabe) des gespeicherten Sprachsignals verändert, die physikalische Reihenfolge (die Reihenfolge der Speicherung) des gespeicherten Sprachsignals bleibt dagegen unverändert.

Diktiergeräte bzw. Textverarbeitungssysteme sollen beim Erstellen von Dokumenten nach Diktat einen guten Bedienkomfort hinsichtlich Textneueingabe, Textumbruch, Textbearbeitung usw. bieten. Um sowohl dem Diktierer als auch der Sekretärin die Arbeit zu erleichtern und um eine rasche Information über den Diktatstand zu ermöglichen, ist es für Magnetband-Speicher bekannt, durch einen Synchron-Indexzeiger in der Bandkassette den genauen Diktatstand zu markieren und den Indexzeiger beispielsweise durch mechanische Betätigung in einer 30-Minuten-Skala zu verschieben. Neben der Diktatstandanzeige an der Bandkassette (Steno-Cassette 30) ist es bei Diktiersystemen mit Band-Speichern auch möglich, bei der Aufnahme die Einzel-Diktate elektronisch zu markieren.

Für eine Mini-Cassette ist eine als visuelles Index-System bezeichnete Ausführungsform zur Markierung des Endes jedes Einzel-Diktats oder nachträglicher Korrekturen oder Hinweise bekannt. Zur Anzeige der vorgenommenen Markierung wird, zusätzlich zum Einschreiben einer elektronischen Marke auf dem Magnetband, eine Marke in einem grünen, magnetischen Indexstreifen gesetzt. Ein senkrechter Strich nach oben im Indexstreifen kennzeichnet das Ende des Einzel-Diktats und ein senkrechter Strich nach unten kennzeichnet eine Korrektur oder einen Hinweis des Diktierers.

Bei der Wiedergabe kann die Sekretärin durch Tastenbestätigung die elektronisch markierten Textstellen automatisch ansteuern und über einen akustischen Hinweiston können vom Diktierer für die Sekretärin Satzeinschübe, Formulierungskorrekturen oder Einfügungen signalisiert werden. Die Sekretärin erkennt mit einem Blick auf die Mini-Cassette die Gesamtdiktatlänge, die Zahl und Länge der Einzel-Diktate und ob Korrekturen, Einfügungen usw. des Diktierers beim Schreiben zu berücksichtigen sind. Solche nachträglichen Einfügungen werden bei einem Magnetbandgerät vom Diktierer auf eine andere Bandcassette (z.B. Steno-Cassette 30) aufgesprochen oder werden in schriftlicher Form beigefügt. Schließlich ist ein Diktiergerät bekannt, bei dem als Diktatträger eine beschriftbare Folie vorgesehen ist. Will der Verfasser beim nochmaligen Abhören des Diktats Korrekturen vornehmen, so sind diese auf die Folie zu schreiben, da keine Löschung der besprochenen Folie möglich ist.

Diktiergeräte mit einem Halbleiterspeicher bieten zwar dem Benutzer einen guten Bedienkomfort, besonders hinsichtlich der Vornahme von Satzeinschüben, Formulierungskorrekturen, Einfügen längerer Textabschnitte usw., der hierfür vorzusehende Schaltungsaufwand ist jedoch beträchtlich. Bei herkömmlichen Diktiergeräten kann in der Regel auf das Magnetband ein 30-Minuten-Diktat aufgesprochen werden. Wird hierfür ein Halbleiterspeicher benutzt, so ist eine Speicherkapazität von 15 MByte erforderlich. Der weiterhin zusätzlich erforderliche Schaltungsaufwand für die Markiereinrichtung bzw. Korrekturablaufsteuerung ist ebenfalls hoch, so daß ein Diktiergerät mit einem Halbleiterspeicher entsprechend der Speicherkapazität eine relativ teuere Lösung ist. Werden serielle Halbleiterspeicher eingesetzt, so kann der Benutzer die Korrekturen nur sequentiell, d.h. ausgehend von der letzten zur vorletzten oder von der ersten zur zweiten Korrekturstelle vornehmen.

Der Erfindung liegt die Aufgabe zugrunde, eine Schaltungsanordnung derart auszugestalten, daß mit geringem Schaltungsaufwand auf einfache Art und Weise die Überarbeitung eines gesprochenen Textes ermöglicht wird.

Diese Aufgabe wird bei einer gattungsgemäßen Schaltungsanordnung durch die kennzeichnenden Merkmale des Patentanspruchs 1 gelöst.

Die erfindungsgemäße Schaltungsanordnung vereinigt durch die Kombination von Magnetband- und Halbleiterspeicher die Vorzüge beider Speicherfamilien und ermöglicht auf überraschend einfache Art und Weise eine Arbeitserleichterung sowohl für den Diktierer als auch für die Sekretärin. Der Benutzer kann die bei herkömmlichen Diktiergeräten gewohnte Arbeitsweise beibehalten.

Die Speicherkapazität des Halbleiterspeichers ist wesentlich geringer als die des Magnetbandspeichers, z.B. ausreichend für ein 3-Minuten-Diktat, so daß mit relativ geringen zusätzlichen Kosten beim Abhören die Überarbeitung eines 3-Minuten-Diktats ermöglicht wird.

Bei der Ausführungsform nach Patentanspruch 1 wird das Diktat im Halbleiterspeicher zwischengespeichert. Für den Fall, daß die Diktatlänge des Einzel-Diktats einen Grenzwert von z.B. 90 % der Speicherkapazität des Halbleiterspeichers überschreitet, wird der Diktierer darauf aufmerksam gemacht. Der Verfasser des Diktats kann nun entweder ohne Abhören des zwischengespeicherten Textes diesen endgültig im Magnetbandspeicher abspeichern oder das Einschreiben in den Magnetbandspeicher erfolgt nach dem Abhören und ggf. Überarbeiten des zwischengespeicherten Textes. Der zwischengespeicherte Text wird entweder beim Einschreiben in den Magnetbandspeicher gelöscht oder durch das nachfolgende weitere Diktat überschrieben.

Bei der Ausführungsform nach Patentanspruch 4 wird der Halbleiterspeicher nur zur Zwischenspeicherung des neuen gesprochenen Textteils eingesetzt. Bei dieser Ausführungsform können ebenfalls Korrekturen in beliebiger Länge und an beliebigen Textstellen vorgenommen werden.

Bei der Ausführungsform nach Patentanspruch 2 wird nur das Ende des auszutauschenden Textabschnitts markiert. Der Vorteil einer solchen Markierung liegt darin, daß der Verfasser des Textes ohnehin weiß, ab welcher Stelle eine Korrektur beginnen soll. Beim nochmaligen Abhören kann der Verfasser des Textes immer noch den Beginn der Korrektur beliebig festlegen. Je nach Länge des neuen Textteiles wird danach der ursprüngliche Text im Halbleiterspeicher verschoben.

Bei der Ausführungsform gemäß Patentanspruch 3 wird der gesprochene Text als analoges Signal in den Magnetbandspeicher eingeschrieben. Hierdurch ist es möglich als Wiedergabegerät herkömmliche Diktiersysteme weiter zu benutzen unabhängig davon, ob eine Digital-Analog-Umsetzung des im Halbleiterspeicher zwischengespeicherten Textes vorgenommen wird oder nicht. Weiterhin besteht die Möglichkeit der Diktatfernübertragung, z.B. über das öffentliche Fernsprechnetz. Im Falle zwischengespeicherter Sprachdaten können diese beispielsweise einem Akustikkoppler zugeführt werden, welcher diese in akustische Signale umwandelt. Dadurch wird eine Textdatenfernübertragung mit niedriger Übertragungsgeschwindigkeit, z.B. 300 Baud, ermöglicht.

Die Ausführungsform gemäß Patentanspruch 5 weist den Vorteil auf, daß im Halbleiterspeicher je nach Länge des neuen, gesprochenen Textteils der nachfolgende ursprüngliche Text von Speicherplatz zu Speicherplatz weitergeschoben oder aufgeschlossen wird, so daß sich das Ende des neuen Textteils nahtlos an den ursprünglichen Text anschließt.

### Durch die unterschiedliche

Einschreib-Auslesegeschwindigkeit des überarbeiteten Textteils gemäß Patentanspruch 6 kann auf einfache Art und Weise das Ende des neuen Textteils nahtlos an den ursprünglichen Text angeschlossen werden. Damit das Diktat noch verständlich bleibt, kann auch ein sogenannter VSC-Prozessor (Variable-Speech-Control) eingesetzt werden, welcher die durch die höhere Auslesegeschwindigkeit bedingte Tonhöhenänderung ausgleicht. Ein solcher VSC-Prozessor ist beispielsweise in der Zeitschrift "NTZ", Band 38 (1985), Heft 5, Seite 355, beschrieben.

Die Ausführungsform gemäß Patentanspruch 7 weist den Vorteil auf, daß auf einem VSC-Prozessor verzichtet werden kann, da die Angleichung des neuen Textteils an den ursprünglichen Text über den gesamten Speicherbereich des Halbleiterspeichers hinweg gemittelt wird.

Die Erfindung wird im folgenden anhand in der Zeichnung dargestellter Ausführungsformen näher beschrieben und erläutert.

Es zeigt:
- Fig. 1: eine erste Ausführungsform mit einem Halbleiterspeicher zur Zwischenspeicherung des zu überarbeitenden Diktats und
- Fig. 2: eine zweite Ausführungsform mit einem Halbleiterspeicher nur zur Zwischenspeicherung des neuen Textteils für die erfindungsgemäße Kombination von Magnetband- und Halbleiterspeicher.

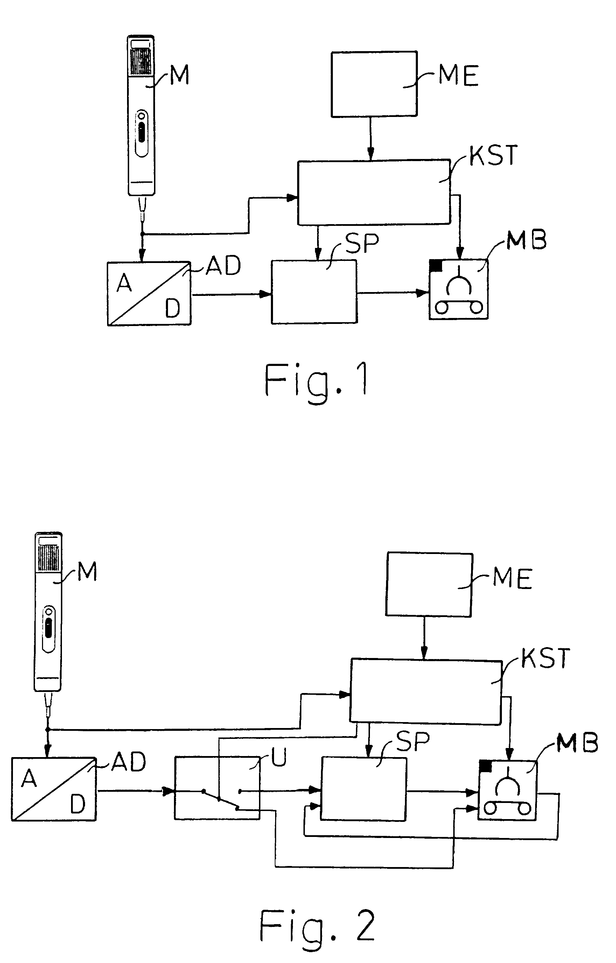

Bei der in Fig. 1 dargestellten Ausführungsform ist ein Halbleiterspeicher SP zur Speicherung von gesprochenen Texten vorgesehen, wobei eine Analog-Digital-Umsetzung im A/D-Umsetzer AD, des vom Mikrofon M kommenden Sprachsignals vorgenommen wird. Mit einer Markiereinrichtung ME können vom Diktierer zu löschende Textteile markiert werden. Weiterhin ist eine Korrektursteuereinrichtung KST vorgesehen, welche je nach Länge des zu löschenden Textteils den nachfolgenden ursprünglichen Text im Halbleiterspeicher SP weiterschiebt oder aufschließt. Die Speicherkapazität des Halbleiterspeichers SP ist wesentlich geringer als die Speicherkapazität eines Magnetbandspeichers MP. Nach dem Abhören und ggf. Überarbeiten des im Halbleiterspeicher SP zwischengespeicherten Textes wird, zur endgültigen Abspeicherung, durch die Korrektursteuereinrichtung KST dieser Text aus dem Halbleiterspeicher SP ausgelesen und in den Magnetbandspeicher MP eingeschrieben. Auf dem Magnetband kann entweder ein digitales oder ein analoges Sprachsignal aufgezeichnet werden. Wird ein analoges Signal aufgezeichnet, so kann als Wiedergabegerät ein herkömmliches Wiedergabegerät ohne Digital-Analog-Umsetzer eingesetzt werden.

In Fig. 2 ist eine weitere Ausführungsform der erfindungsgemäßen Kombination von Magnetband- und Halbleiterspeicher MB, SP dargestellt. Der Halbleiterspeicher SP dient bei dieser Ausführungsform nur zur Zwischenspeicherung des neuen gesprochenen Textteils. Dieser wird über einen mit der Korrektursteuereinrichtung KST und dem Umsetzer AB verbundenen Umschalter U dem Halbleiterspeicher SP zugeführt. Die Korrektursteuereinrichtung KST löscht beim Abhören und Markieren jeweils den zwischen zwei Markierungen auf dem Magnetbandspeicher MB befindlichen Textteil. Für den Fall, daß der neue Textteil kürzer oder länger als der ursprüngliche Textteil ist oder daß dieser vollständig entfällt, kann eine Verschiebung des gesamten ursprünglichen Textes vorgenommen werden. Zur Verschiebung des nachfolgenden, auf dem Magnetbandspeicher MB befindlichen Textes, wird dieser in den Halbleiterspeicher SP eingelesen und die Korrektursteuereinrichtung KST verschiebt den nachfolgenden, ursprünglichen Text nunmehr im Halbleiterspeicher SP derart, daß sich das Ende des neuen Textteils nahtlos an den ursprünglichen Text anschließt.

Eine weitere Möglichkeit den neuen Textteil nahtlos an den ursprünglichen Text anzuschließen besteht darin, daß die Korrektursteuereinrichtung KST den Einschreib- und Auslesevorgang für den Halbleiterspeicher SP oder die Einschreibvorgänge in den Magnetbandspeicher MB mit unterschiedlicher Geschwindigkeit ablaufen läßt. Die dadurch bedingte Tonhöhenänderung kann durch einen VSC-Prozessor ausgeglichen werden.

Im Falle, daß kein VSC-Prozessor eingesetzt werden soll und der neue Textteil wesentlich länger (oder kürzer) als der ursprüngliche Textteil ist, schreibt die Korrektursteuereinrichtung KST automatisch beim Erreichen der zweiten Markierung den ursprünglichen und nicht zu löschenden Textteil in den Halbleiterspeicher SP ein. Da die Zwischenspeicherung über den Gesamtspeicherbereich des Halbleiterspeichers SP hinweg erfolgt, muß der Lesetakt des Halbleiterspeichers SP in der Regel nur geringfügig erhöht (oder verkleinert) werden. Das auf dem Magnetband aufgezeichnete Diktat bleibt weiterhin verständlich und beim Abhören des Diktats kann die Sekretärin die Differenz annähernd wieder ausgleichen (in der Regel kann die Wiedergabegeschwindigkeit um 15% erhöht oder verringert werden).

## Patentansprüche

1. Schaltungsanordnung mit einem Halbleiterspeicher (SP) und einem Magnetbandspeicher (MB) zur Speicherung von gesprochenen Texten, wobei die Speicherkapazität des Halbleiterspeichers (SP) wesentlich geringer als die des Magnetbandspeichers (MB) ist, der über ein Mikrofon (M) eingesprochene Text nach Analog-Digital-Umsetzung (AD) in dem Halbleiterspeicher (SP) zwischengespeichert wird, nach Abhören und gegebenenfalls Überarbeiten, insbesondere Einfügen von Textteilen in den Text, des im Halbleiterspeicher (SP) zwischengespeicherten Textes, wobei eine Korrektursteuereinrichtung (KST) je nach Länge des zu löschenden Textteils den nachfolgenden, ursprünglichen Text im Halbleiterspeicher (SP) weiterschiebt oder aufschließt, der zwischengespeicherte Text zur endgültigen Abspeicherung in den Magnetbandspeicher (MB) eingeschrieben wird und die Schaltungsanordnung mit einer Markiereinrichtung (ME) zur Markierung von zu löschenden Textteilen und die Korrektursteuereinrichtung (KST) mit der Markiereinrichtung (ME), dem Halbleiterspeicher (SP) und/oder dem Magnetbandspeicher (MB) verbunden ist.

2. Schaltungsanordnung nach Anspruch 1,
**dadurch gekennzeichnet**, daß beim Abhören des zwischengespeicherten Textes nur das Ende der auszutauschenden Textteile markiert wird.

3. Schaltungsanordnung nach Anspruch 1,
**dadurch gekennzeichnet**, daß der im Halbleiterspeicher (SP) zwischengespeicherte Text nach D/A-Umsetzung in den Magnetbandspeicher (MB) eingeschrieben wird.

4. Schaltungsanordnung nach dem Oberbegriffdes Patentanspruchs 1,
**dadurch gekennzeichnet**, daß der über ein Mikrofon (M) eingesprochene neue Textteil nach Analog-Digital-Umsetzung (AD) in den Halbleiterspeicher (SP) eingeschrieben wird und die Speicherkapazität des Halbleiterspeichers (SP) wesentlich geringer als die Speicherkapazität des Magnetbandspeichers (MB) ist und daß die Korrektursteuereinrichtung (KST) den neuen Textteil aus dem Halbleiterspeicher (SP) ausliest und den zwischen den zwei Markierungen in dem Magnetbandspeicher (MB) befindlichen, ursprünglichen Textteil überschreibt.

5. Schaltungsanordnung nach Anspruch 4,
**dadurch gekennzeichnet**, daß die Korrektursteuereinrichtung (KST) beim Abhören und Markieren jeweils den zwischen zwei Markierungen in dem Magnetbandspeicher (MB) befindlichen Textteil löscht und daß die Korrektursteuereinrichtung (KST) zur Verschiebung des nachfolgenden, in dem Magnetbandspeicher (MB) befindlichen Textes diesen in den Halbleiterspeicher (SP) einschreibt und derart ausliest, daß sich das Ende des neuen Textteiles nahtlos an den ursprünglichen Text anschließt.

6. Schaltungsanordung nach Anspruch 5,
**dadurch gekennzeichnet**, daß die Korrektursteuereinrichtung (KST) mit dem Steuereingang eines Umschalters (U) verbunden ist und das Auslesen des überarbeiteten Textteils aus dem Halbleiterspeicher (SP) und das Einschreiben in den Magnetbandspeicher (MB) derart steuert, daß sich das Ende des neuen Textteils nahtlos an den ursprüngliche Text anschließt.

7. Schaltungsanordnung nach Anspruch 6,
**dadurch gekennzeichnet**, daß im Falle eines längeren oder kürzeren neuen Textteils die Korrektursteuereinrichtung (KST) automatisch beim Erreichen der zweiten Markierung den ursprünglichen und nicht zu löschenden Textteil in den Halbleiterspeicher (SP) so lange einschreibt, bis dieser vollständig gefüllt ist oder daß die Korrektursteuereinrichtung (KST) den Einschreib- und Auslesevorgang für den Halbleiterspeicher (SP) oder die Einschreibvorgänge in den Magnetbandspeicher (MB) mit unterschiedlicher Geschwindigkeit ablaufen läßt.

## Claims

1. Circuit arrangement having a semiconductor memory (SP) and a magnetic-tape memory (MB) for storing spoken texts, wherein the memory capacity of the semiconductor memory (SP) is substantially smaller than that of the magnetic-tape memory (MB), the text recorded via a microphone (M) is temporarily stored after analog/digital conversion (AD) in the semiconductor memory (SP), the temporarily stored text is written into the magnetic-tape memory (MB) for final storage after being listened to and optionally edited, in particular after insertion of text sections into the text of the temporarily stored text in the semiconductor memory (SP), a correction control device (KST) routing onward or erasing the subsequent original text in the semiconductor memory (SP) depending on the length of the text section to be erased, and the circuit arrangement is connected to a marking device (ME) for marking text sections to be erased and the correction control device (KST) is connected to the marking device (ME), the semiconductor memory (SP) and/or the magnetic-tape memory (MB).

2. Circuit arrangement according to Claim 1, characterized in that, when the temporarily stored text is listened to, only the end of the text parts to be interchanged is marked.

3. Circuit arrangement according to Claim 1, characterized in that the text temporarily stored in the semiconductor memory (SP) is written into the magnetic-tape memory (MB) after D/A conversion.

4. Circuit arrangement according to the preamble of Patent Claim 1, characterized in that the new text section recorded via a microphone (M) is written after analog/digital conversion (AD) into the semiconductor memory (SP) and the memory capacity of the semiconductor memory (SP) is substantially smaller than the memory capacity of the magnetic-tape memory (MB), and in that the correction control device (KST) reads out the new text section from the semiconductor memory (SP) and overwrites the original text section located between the two markings in the magnetic-tape memory (MB).

5. Circuit arrangement according to Claim 4, characterized in that the correction control device (KST) erases, during listening to and marking, the respective text section located between two markings in the magnetic-tape memory (MB), and in that the correction control device (KST) for routing on the subsequent text located in the magnetic-tape memory (MB) writes the latter into the semiconductor memory (SP) and reads it out in such a way that the end of the new text section seamlessly adjoins the original text.

6. Circuit arrangement according to Claim 5, characterized in that the correction control device (KST) is connected to the control input of a switch (U) and controls the reading-out of the edited text section from the semiconductor memory (SP) and the writing into the magnetic-tape memory (MB) in such a way that the end of the new text section seamlessly adjoins the original text.

7. Circuit arrangement according to Claim 6, characterized in that, in the case of a longer or shorter new text section, the correction control device (KST) automatically writes the original text section not to be erased into the semiconductor memory (SP) on reaching the second marking until said semiconductor memory is completely filled or in that the correction control device (KST) allows the writing-in and reading-out process for the semiconductor memory (SP), or the writing-in processes for the magnetic-tape memory (MB) to proceed at different speed.

## Revendications

1. Montage comportant une mémoire à semiconducteurs (SP) et une mémoire à bande magnétique (MB) pour la mémorisation de textes parlés, dans lequel la capacité de la mémoire à semiconducteurs (SP) est nettement inférieure à celle de la mémoire à bande magnétique (MB), le texte dans un microphone (M) est mémorisé temporairement, après conversion analogique / numérique (AD), dans la mémoire à semiconducteurs (SP), après écoute et éventuellement traitement du texte mémorisé temporairement dans la mémoire à semiconducteurs, et notamment insertion de parties de texte dans le texte, et dans lequel un dispositif de commande de correction (KST) fait avancer ou décale le texte initial suivant dans la mémoire à semiconducteurs (SP), en fonction de la longueur de la partie de texte à effacer, le texte mémorisé temporairement est inscrit, pour une mémorisation finale, dans la mémoire à bande magnétique (MB), et le montage est relié à un dispositif de marquage (ME) servant à marquer des parties de texte à effacer, et le dispositif de correction (KST) est relié au dispositif de marquage (ME), à la mémoire à semiconducteurs (SP) et/ou à la mémoire à bande magnétique (MB).

2. Montage selon la revendication 1, caractérisé en ce que lors de l'écoute du texte mémorisé temporairement, seule la fin des parties de texte à échanger est marquée.

3. Montage selon la revendication 1, caractérisé en ce que le texte mémorisé temporairement dans la mémoire à semiconducteurs (SP) est inscrit, après conversion numérique/analogique, dans la mémoire à bande magnétique (MB).

4. Montage selon le préambule de la revendication 1, caractérisé en ce que la nouvelle partie de texte prononcée avec utilisation d'un microphone (M) est inscrite, après conversion analogique/numérique (AD), dans la mémoire à semiconducteurs (SP) et la capacité de la mémoire à semiconducteurs (SP) est nettement inférieure à la capacité de la mémoire à bande magnétique (MB) et que le dispositif de commande de correction (KST) lit la nouvelle partie de texte à partir de la mémoire à semiconducteurs (SP) et réalise un enregistrement en surinscription sur la partie de texte initiale, située entre les deux marques dans la mémoire à bande magnétique (MB).

5. Montage selon la revendication 4, caractérisé en ce que lors de l'écoute et du marquage, le dispositif de commande de correction (KST) efface respectivement la partie de texte située entre les deux marques dans la mémoire à bande magnétique (MB), et que pour le déplacement du texte suivant situé dans la mémoire à bande magnétique (MB), le dispositif de commande de correction (KST) inscrit ce texte dans la mémoire à semiconducteurs (SP) et effectue une lecture de telle sorte que l'extrémité de la nouvelle partie de texte se raccorde directement au texte initial.

6. Montage selon la revendication 5, caractérisé en ce que le dispositif de commande de correction (KST) est relié à l'entrée de commande d'un commutateur (U) et commande la lecture de la partie de texte remaniée à partir de la mémoire à semiconducteurs (SP) et l'inscription dans la mémoire à bande magnétique (MB) de sorte que la fin de la nouvelle partie de texte se raccorde directement au texte initial.

7. Montage selon la revendication 6, caractérisé en ce que dans le cas d'une nouvelle partie de texte plus longue ou plus courte, le dispositif de commande de correction (KST) inscrit automatiquement la partie de texte initiale, qui ne doit pas être effacée, dans la mémoire à semiconducteurs (SP) lorsque la seconde marque est atteinte, jusqu'à ce que cette mémoire à semiconducteurs soit complètement remplie, ou que le dispositif de commande de correction (KST) exécute le processus d'écriture et de lecture pour la mémoire à semiconducteurs (SP) ou les processus d'écriture dans la mémoire à bande magnétique (MB) avec des vitesses différentes.
